# FASCICULE DE BREVET EUROPEEN

(11) **EP 3 536 659 B1**
(45) Date de publication et mention de la délivrance du brevet: **29.06.2022**
(21) Numéro de dépôt: 19161029.4
(22) Date de dépôt: 06.03.2019
(51) Int. Cl.: B81B 7/00

(54) **SYSTÈME ÉLECTRONIQUE COMPRENANT UN MICROSYSTÈME ÉLECTROMÉCANIQUE ET UN BOITIER ENCAPSULANT CE MICROSYSTÈME ÉLECTROMÉCANIQUE**
ELEKTRONISCHES SYSTEM MIT EINEM MIKROELEKTROMECHANISCHEN SYSTEM UND EINEM BAUTEILPAKET, DAS DIESES MIKROELEKTROMECHANISCHES SYSTEM ENTHÄLT
ELECTRONIC SYSTEM COMPRISING A MICROELECTROMECHANICAL SYSTEM AND A DEVICE PACKAGE ENCAPSULATING THIS MICROELECTROMECHANICAL SYSTEM

(30) Priorité: 07.03.2018 FR 1800197
(43) Date de publication de la demande: 11.09.2019
(73) Titulaire: THALES, 92400 Courbevoie (FR)
(72) Inventeur: LEVERRIER, Bertrand, 26000 Valence Cedex (FR); SARNO, Claude, 26000 Valence Cedex (FR); ROUGEOT, Claude, 26000 Valence Cedex (FR); HODOT, Romain, 26000 Valence Cedex (FR)
(74) Mandataire: Lavoix

(56) Documents cités:
- US-A1- 2003 038 415
- US-A1- 2010 300 201
- US-A1- 2017 275 157

## Description

La présente invention concerne un système électronique comprenant un microsystème électromécanique et un boitier hermétique encapsulant ce microsystème électromécanique.

De manière connue, un microsystème électromécanique est un microsystème comprenant un ou plusieurs éléments qui utilise l'électricité comme source d'énergie, en vue de réaliser une fonction de capteur et/ou d'actionneur avec au moins une structure présentant des dimensions micrométriques, et dont la fonction est en partie assurée par la forme de cette structure. Le terme microsystème électromécanique est la version française de l'acronyme anglais MEMS (pour « Microelectromechanical systems »).

Pour assurer le bon fonctionnement d'un microsystème électromécanique résonant, celui-ci est généralement monté dans un boitier hermétique sous vide, fait par exemple d'un matériau céramique. Ce boitier comporte des contacts électriques nécessaires pour mettre en oeuvre la transmission de données et éventuellement de l'énergie électrique entre le microsystème électromécanique et un système externe.

Un tel boitier est décrit notamment dans le document FR 2958451.

Par ailleurs, pour assurer la fixation stable du microsystème électromécanique dans le boitier tout en préservant les performances du microsystème, il est connu du document FR 2966813 d'utiliser des poutres flexibles, appelées également bras de découplage, raccordant le microsystème au boitier. Ces bras de découplage, compte tenu de leur nature flexible, permettent d'absorber les dilatations différentielles entre le système MEMS et le boitier.

Un microsystème électromécanique peut par exemple présenter un actionneur ou un capteur, notamment un capteur inertiel ou un oscillateur.

Il est connu qu'un tel microsystème électromécanique présente en fonctionnement une sensibilité élevée aux variations des températures externes. Ainsi, il est souvent nécessaire d'assurer un contrôle thermique du microsystème électromécanique afin d'assurer l'homogénéité de la précision de ses mesures ou de ses actions. Cela est particulièrement le cas lorsque le microsystème électromécanique est utilisé dans des applications dites sensibles que l'on peut retrouver notamment dans le domaine aéronautique ou le domaine spatial.

Classiquement, pour mettre en oeuvre un contrôle thermique d'un microsystème électromécanique, l'état de la technique propose l'utilisation d'un module Peltier à proximité d'une partie sensible de ce microsystème. Ce module permet soit de réchauffer soit de refroidir la partie sensible ou tout le système MEMS. Une autre solution consiste à rajouter un élément résistif qui par effet Joule permet de réchauffer la partie sensible ou tout le système MEMS.

On connait également les documents US 2010/300201 A1 et US 2017/275157 A1 décrivant chacun un microsystème électromécanique comportant un élément chauffant pour assurer un contrôle thermique.

Toutefois, les solutions précitées ne sont pas complètement satisfaisantes.

En particulier, dans certains cas, compte tenu de contraintes imposées notamment par le boitier, ces solutions sont mises en oeuvre trop loin du système MEMS de sorte qu'une forte puissance est nécessaire pour assurer le bon fonctionnement de l'ensemble. Dans d'autres cas, lorsque ces solutions sont appliquées directement au système MEMS, il est nécessaire pour le fonctionnement de l'ensemble de rajouter dans ce système des matériaux hétérogènes. Cela génère des contraintes de report et de dilation différentielles ce qui dégrade les performances de stabilité à long terme des microsystèmes électromécaniques. De plus, cela rajoute des étapes supplémentaires lors de la production de ces systèmes.

La présente invention pour a but de proposer un système électronique avec une régulation thermique pour un système MEMS qui est particulièrement compact et qui ne nécessite pas de rajout de matériaux supplémentaires notamment sur ce système MEMS.

L'invention permet ainsi d'assurer la régulation thermique efficace et précise du système MEMS sans dégrader les performances de celui-ci.

À cet effet, l'invention a pour objet un système électronique conforme à l'objet de la revendication 1.

Suivant d'autres aspects avantageux de l'invention, le système comprend une ou plusieurs caractéristiques des revendications 2 à 14.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue en coupe d'un système électronique selon un premier mode de réalisation de l'invention, le système électronique comportant notamment un boitier ;
- la figure 2 est une vue de dessus du boitier de la figure 1 ;
- la figure 3 est une vue en coupe du système électronique de la figure 1 selon un aspect avantageux de l'invention ;
- la figure 4 est une vue en coupe d'un système électronique selon un deuxième mode de réalisation de l'invention, le système électronique comportant notamment un boitier ; et
- la figure 5 est une vue de dessus du boitier de la figure 4.

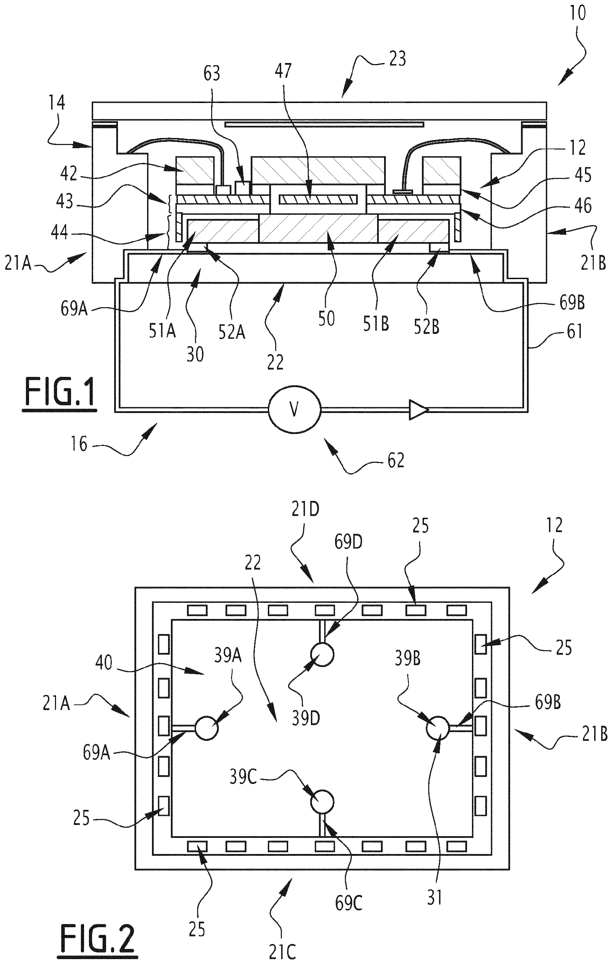

Le système électronique 10 de la figure 1 est par exemple un capteur, de préférence un capteur inertiel. Il est par exemple utilisable à bord d'un aéronef pour mesurer sa vitesse angulaire et/ou son accélération.

Selon un autre exemple de réalisation, le système électronique 10 est une horloge à résonateur en silicium.

Selon d'autres exemples de réalisation, le système électronique selon l'invention correspond à tout autre système électronique nécessitant un contrôle thermique tel qu'un oscillateur ou un actionneur de haute précision.

En référence à la figure 1, le système électronique 10 comprend un microsystème électromécanique 12, un boitier hermétique 14 sous vide encapsulant ce microsystème électromécanique 12 et un régulateur thermique 16 notamment du microsystème électromécanique 12.

Le boitier 14 est fait par exemple en plusieurs couches de céramique et se présente par exemple sous une forme parallélépipédique formée de quatre parois latérales 21A à 21D (visibles également sur la figure 2), d'un fond de boitier 22 et d'un couvercle 23.

De manière connue en soi, les parois latérales 21A à 21D comprennent des contacts électriques de sortie 25 raccordant notamment le microsystème électromécanique 12 à des systèmes externes et permettant la transmission des signaux, notamment des signaux analogiques, entre ces différents systèmes.

Le couvercle 23 est également connu en soi et permet notamment de fermer le boitier 14 de manière hermétique sous vide, lorsque le microsystème électromécanique 12 est monté dans celui-ci.

Le fond de boitier 22 comprend une base céramique 30 formant une face extérieure disposée en contact avec le milieu extérieur du boitier 14 et une face intérieure.

Selon le premier mode de réalisation de l'invention, le fond de boitier 22 comprend en outre une couche métallisée 31 couvrant partiellement la face intérieure de la base céramique 30.

En particulier, la couche métallisée 31 définit une pluralité de points de fixation désignés par les références générales 39A à 39D sur la figure 2.

Les points de fixation 39A à 39D sont par exemple disposés de manière symétrique par rapport à un axe perpendiculaire au fond de boitier 22. Le nombre de ces points de fixation 39A à 39D correspond à celui d'éléments de fixation expliqués en détail par la suite.

Par ailleurs, dans la couche métallisée 31, les points de fixation 39A à 39D sont isolés électriquement l'un de l'autre. Cela est fait par exemple en brisant la continuité de la couche métallisée 31 pour isoler les zones comprenant ces points de fixations 39A à 39D.

La couche métallisée 31 avec les points de fixation 39A à 39D forment un plan de fixation 40.

De manière générale, le boitier 14 est par exemple conforme à l'un des exemples décrits dans le document FR 2958451.

Le microsystème électromécanique 12, connu également sous le terme « MEMS » ou « système MEMS » permet de mettre en oeuvre le fonctionnement du système électronique 10.

En particulier, en référence à la figure 1, le microsystème électromécanique 12 est constitué de trois couches conductrices électriquement, à savoir une couche supérieure 42, une couche intermédiaire 43 et une couche inférieure 44, et de deux couches isolantes électriquement 45, 46 disposées entres ces couches conductrices 42 à 44.

Chaque couche conductrice 42 à 44 est faite d'un matériau au moins partiellement conducteur, par exemple d'un matériau fortement dopé de silicium.

Chaque couche isolante 45, 45 permet d'isoler électriquement les couches conductrices 42 à 44 entre elles et est faite par exemple d'un oxyde de silicium.

La couche intermédiaire 43 définit notamment une partie sensible 47 gravée par exemple au centre de cette couche 43. La partie sensible 47 assure notamment la fonction d'un gyroscope et/ou d'un accéléromètre et permet de mesurer respectivement la vitesse angulaire ou l'accélération du système électronique 10, selon un ou plusieurs axes. Selon un autre exemple de réalisation, la partie sensible 47 assure la fonction d'un résonateur.

La couche intermédiaire 43 est raccordée aux contacts électriques du boitier 14 par des moyens de raccordement adaptés afin de pouvoir recevoir ou/et émettre des signaux, notamment des signaux analogiques, en provenance des systèmes externes ou/et vers ces systèmes.

La précision des mesures fournies par la couche intermédiaire 43 dépend par exemple de la température du milieu en contact avec cette couche.

La couche supérieure 42 est optionnelle et présente notamment un capot permettant de préserver la partie sensible 47 des poussières lors du montage du microsystème électromécanique 12 dans le boitier 14.

La couche inférieure 44 comporte un substrat central 50 en contact avec la couche isolante 46 et supportant cette couche 46 ainsi que les couches 42, 43, 45 et une pluralité de poutres disposées par exemple autour du substrat central 50.

Chaque poutre présente avantageusement un bras de découplage.

Les bras de découplage permettent de fixer le microsystème électromécanique 12 au plan de fixation 40 de manière souple via un élément de fixation défini pour chacun de ces bras. Chaque bras de découplage est déformable en flexion et permet ainsi de découpler les mouvements du microsystème électromécanique 12 du boitier 14.

Dans l'exemple de réalisation des figures 1 et 2, la couche inférieure 44 comporte quatre bras de découplage et donc quatre éléments de fixation associés à ces bras de découplage. Seuls deux bras de découplage désignés par les références générales 51A, 51B, et deux éléments de fixation désignés par les références générales 52A, 52B, sont visibles sur la figure 1.

Les bras de découplage sont par exemple disposés de manière symétrique par rapport à un axe perpendiculaire au plan de fixation 40 et s'étendent par exemple selon les directions définies par les parois latérales 21A à 21D du boitier 14, sans avoir de points d'interception entre eux.

Les éléments de fixation sont faits également d'un matériau au moins partiellement conducteur et sont fixés au plan de fixation 40 sur les points de fixation 39A à 39D, par exemple par des brasures ou de la colle conductrice.

De manière générale, les bras de découplage peuvent être implémentés selon l'un quelconque des exemples mentionnés dans le document FR 2966813.

Selon un exemple de réalisation, le substrat central 50 permet de coupler électriquement l'ensemble des bras de fixation.

Selon un autre exemple de réalisation, le substrat central 50 permet de coupler électriquement entre eux chaque couple de bras de découplage en formant une pluralité de couples connectés. Ainsi, les bras de découplage appartenant à des couples connectés différents sont isolés électriquement entre eux.

Par ailleurs, le substrat central 50 est isolé électriquement de la couche intermédiaire 43 via la couche isolante 46 tout en restant couplé thermiquement à cette couche intermédiaire 43.

Dans l'exemple de réalisation de la figure 1, le régulateur thermique 16 comporte un circuit électrique 61, un contrôleur de circuit 62 et avantageusement, un capteur élémentaire 63.

Le capteur élémentaire 63 est apte à mesurer au moins un paramètre de la partie sensible 47 variant en fonction de la température de celle-ci. Ce paramètre peut être par exemple directement la température ou alors tout autre paramètre physique tel que la dilation ou compression de cette partie ou de la couche intermédiaire 43 en générale, selon un ou plusieurs axes.

Le contrôleur de circuit 62 est raccordé au capteur élémentaire 63 et est apte à engendrer un courant électrique dans le circuit électrique 61 en fonction de ce paramètre pour modifier, notamment pour augmenter, la température de la partie sensible 47.

Le contrôleur de circuit 62 se présente par exemple sous la forme d'un contrôleur électronique programmable connecté à une source d'alimentation (une batterie par exemple) et définissant une borne positive et une borne négative. Ce contrôleur 62 est programmé par exemple de sorte à fournir une différence de tensions sur ses bornes de valeur déterminée en fonction du paramètre fourni par le capteur élémentaire 63 ou une différence de tensions de valeur prédéterminée.

Le contrôleur de circuit 62 est disposé par exemple à l'extérieur du boitier 14.

Le circuit électrique 61 est connecté aux bornes du contrôleur 62 et définit en outre une extrémité 69A à 69D pour chaque point de fixation 39A à 39D. Autrement dit, le circuit électrique 61 permet de raccorder électriquement chaque point de fixation 39A à 39D à la borne positive ou négative du contrôleur de circuit 62.

Avantageusement, lorsque les bras de découplage forment plusieurs couples connectés isolés électriquement, le circuit électrique 61 permet de raccorder électriquement le point de fixation correspondant au bras de découplage de l'un des couples à la borne positive et le point de fixation correspondant à l'autre bras de découplage du même couple à la borne négative.

Dans l'exemple décrit, les points de fixation 39A, 39D sont raccordés à la borne positive du contrôleur de circuit 62 et les points de fixation 39B, 39C sont raccordés à la borne négative du contrôleur de circuit 62.

À l'extérieur du boitier 14, le circuit électrique 61 se présente par exemple sous la forme d'une pluralité de câbles électriques isolés l'un de l'autre.

À l'intérieur du boitier 14 et éventuellement à l'intérieur de ses parois, le circuit électrique 61 se présente par exemple sous la forme d'une pluralité de câbles électriques ou d'une pluralité de pistes formées dans la couche métallisée 31 de manière analogue aux points de fixation 39A à 39D.

Dans l'exemple de la figure 2, les extrémités 69A à 69D sont sous la forme des pistes formées dans la couche métallisée 31, conduisant vers les points de fixation 39A à 39D correspondants.

Le fonctionnement du système électrique 10 selon le premier mode de réalisation sera désormais expliqué.

Initialement, la couche intermédiaire 43 et notamment, la partie sensible 47 ont la température par exemple inférieure à une température de fonctionnement nominal.

Cette température est mesurée par le capteur élémentaire 63 qui transmet ensuite les données correspondantes au contrôleur de circuit 62.

Ce dernier analyse les données reçues et crée sur ses bornes une différence de tensions de valeur déterminée en fonction des données reçues ou une différence de tensions de valeur prédéterminée.

Cela engendre alors un courant dans le circuit électrique 61.

Le courant engendré passe via les bras de découplage et compte tenu de leur résistance, les réchauffe. Cela réchauffe alors le substrat central 50 qui transmet la chaleur à la couche intermédiaire 43 et notamment à la partie sensible 47, compte tenu du couplage thermique entre ces différentes composantes.

Lorsque, en analysant les données fournies par le capteur élémentaire 63, le contrôleur de circuit 62 estime que la température de fonctionnement nominal est atteinte, il coupe l'alimentation du circuit électrique 61.

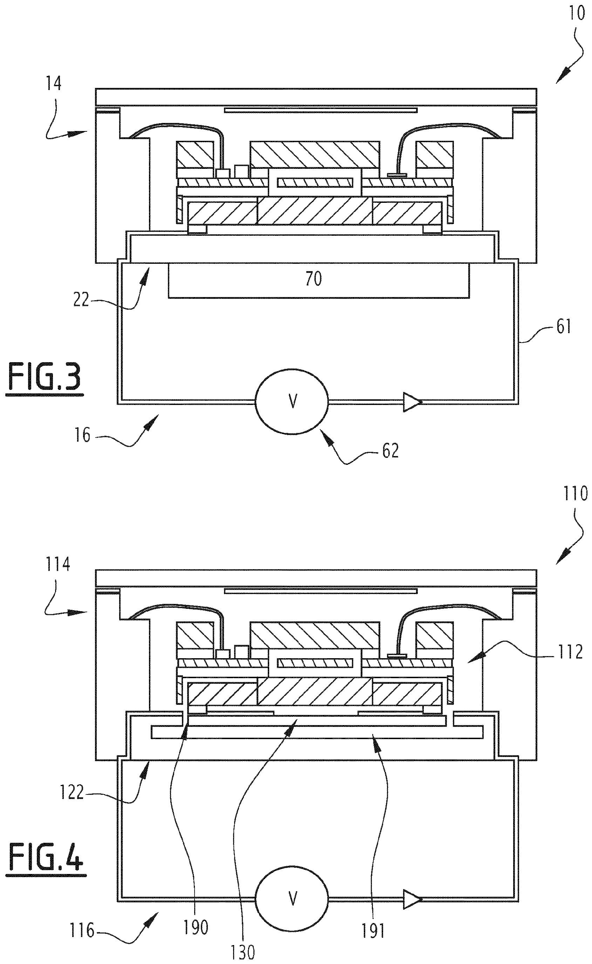

Selon l'aspect avantageux de l'invention illustré sur la figure 3, le régulateur thermique 16 comporte en outre un module Peletier 70 connu en soi.

Ce module Peletier 70 est disposé par exemple en contact avec la face extérieure de la base céramique 30 du boitier 14. Selon un autre exemple de réalisation, ce module 70 est disposé à l'intérieur du boitier 14.

Le fonctionnement du module Peletier 70 est par exemple contrôlé par le contrôleur 62.

Ainsi, en fonction des données fournies par le capteur élémentaire 63, le contrôleur 62 peut par exemple activer le fonctionnement du module 70 afin de refroidir le fond de boitier 22 et donc le microsystème électromécanique 12.

On conçoit alors que l'invention présente un certain nombre d'avantages.

Tout d'abord, l'invention évite tout ajout de composantes supplémentaires à l'intérieur du boitier et notamment l'ajout de matériaux supplémentaires sur microsystème électromécanique. Ainsi, selon l'invention, aucune contrainte supplémentaire n'est rajoutée sur le microsystème électromécanique ce qui rallonge sa durée de vie et permet de garder le boitier relativement compact. De plus, aucune étape supplémentaire de production n'est nécessaire lors du montage du microsystème électromécanique dans le boitier.

En outre, l'invention permet d'appliquer le réchauffement directement sur le microsystème électromécanique et même sur la partie sensible de celui-ci. Étant donné que le microsystème électromécanique est packagé sous vide, cela diminue les déperditions thermiques et donc limite la puissance nécessaire.

Finalement, la solution proposée peut être combinée facilement avec l'utilisation d'un module Peltier pour notamment pouvoir refroidir le microsystème électromécanique.

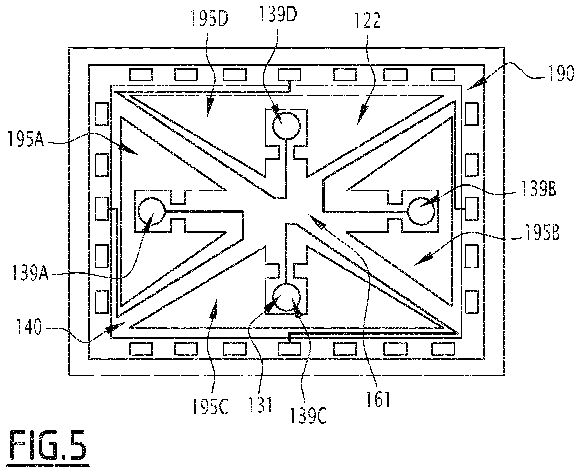

Un système électronique 110 selon un deuxième mode de réalisation est illustré schématiquement sur les figures 4 et 5.

Ce système électronique 110 est analogue au système électronique 10 décrit précédemment et comporte notamment un microsystème électromécanique 112 et un régulateur thermique 116 sensiblement identiques respectivement au microsystème électromécanique 12 et au régulateur thermique 16 décrits précédemment. Ces composantes ne seront donc pas décrites en référence au deuxième mode de réalisation.

Le système électronique 110 comporte en outre un boitier 114 qui diffère du boitier 14 décrit précédemment par son fond de boitier 122 et en ce qu'il comporte en outre une plateforme 190 reportée du fond de boitier 122 en formant ainsi une couche de vide 191.

En effet, selon le deuxième mode de réalisation, le fond de boitier 122 est par exemple homogène et est fait sensiblement entièrement d'un même matériau ou d'une pluralité de couches d'un même matériau, comme par exemple la céramique.

La plateforme 190 comprend en revanche une base 130, par exemple en céramique, et une couche métallisée 131 couvrant partiellement la base 130. La couche métallisée 131 est analogue à la couche 31 décrite précédemment. En particulier, la couche métallisée 131 définit des points de fixation 139A à 139D analogues aux points de fixations 39A à 39D.

La plateforme 190 forme donc un plan de fixation 140 reportée du fond de boitier 22. Le rôle de fixation de ce plan 140 reste analogue à celui du plan 40.

Par ailleurs, la plateforme 190 est fixée par exemple sur les parois latérales du boitier 114 en utilisant des bras de fixation adaptés.

Selon l'aspect avantageux du deuxième mode de réalisation visible en détail sur la figure 5, la plateforme 190 est ajourée et forme par exemple quatre ouvertures 195A à 195D.

Ces ouvertures 195A à 195D sont par exemple de forme triangulaire de sorte que la base 130 de la plateforme 190 se présente sous la forme d'un cadre rectangulaire traversé par deux traversants suivant chaque diagonale du rectangle.

Dans ce cas, les parties d'un circuit électrique 161 du régulateur thermique 116 qui se trouvent à l'intérieur du boitier 114, prennent une forme adaptée pour parvenir aux points de fixation 139A à 139D.

En particulier, dans l'exemple de la figure 5, ces parties se présentent sous la forme de pistes formées dans la couche métallisée 131 qui suivent d'abord le cadre et puis une moitié de l'un des traversants diagonaux formant la plateforme 190.

Selon ce mode de réalisation, un module Peltier peut être également intégré dans le système, par exemple à l'intérieur du boitier 14.

Le fonctionnement du système 110 selon ce mode de réalisation est analogue est fonctionnement du système 10 décrit précédemment.

L'avantage particulier du deuxième mode de réalisation de l'invention consiste en la présence d'une couche de vide entre la partie sensible et le fond de boitier. Cela assure alors une isolation thermique accrue de l'élément sensible et diminue les performances nécessaires au réchauffement de celui-ci.

De plus, la forme particulière de la base en céramique permet de diminuer la conduction thermique des bras de découplage et d'améliorer ainsi encore l'isolation thermique de la partie sensible.

Bien entendu, d'autres modes de réalisation sont également possibles.

Par ailleurs, il est clair que dans l'ensemble des modes de réalisation la régularisation thermique du microsystème électromécanique s'effectue principalement grâce aux poutres, le module Peletier ou tout autre élément chauffant étant optionnels.

## Revendications

1. Système électronique (10 ; 110) comprenant un microsystème électromécanique (12 ; 112) et un boitier hermétique (14 ; 114) sous vide encapsulant ce microsystème électromécanique (12 ; 112) ;
le boitier (14 ; 114) comportant un plan de fixation (40 ; 140) ;
le microsystème électromécanique (12 ; 112) comportant :
- une partie sensible (47) ; et
- au moins deux poutres (51A, 51B) reliant la partie sensible (47) au plan de fixation (40 ; 140) ;
le système (10 ; 110) étant **caractérisé** :
- **en ce que** chaque poutre (51A, 51B) est faite d'un matériau au moins partiellement conducteur ; et
- **en ce que** les poutres (51A, 51B) sont couplées thermiquement à la partie sensible (47) et sont couplées électriquement l'une à l'autre ; et
- **en ce qu'**il comporte en outre un régulateur thermique (16; 116) du microsystème électromécanique (12; 112) comportant un circuit électrique (61 ; 161) comportant au moins deux extrémités (69A,...,69D) reliées aux poutres (51A, 51B), et un contrôleur de circuit (62) apte à engendrer un courant électrique dans le circuit électrique (61 ; 161) pour modifier la température de la partie sensible (47).

2. Système (10; 110) selon la revendication 1, dans lequel le régulateur thermique (16 ; 116) comporte en outre un capteur élémentaire (63) apte à mesurer au moins un paramètre de la partie sensible (47) variant en fonction de la température de celle-ci ;
le contrôleur de circuit (62) étant apte à engendrer un courant électrique dans circuit électrique (61 ; 161) en fonction des mesures fournies par le capteur élémentaire (63).

3. Système (10 ; 110) selon la revendication 1 ou 2, dans lequel chaque poutre (51A, 51B) est reliée au plan de fixation (40 ; 140) via un élément de fixation (52A, 52B) intégré dans ce plan (40 ; 140) dans un point de contact (39A,...,39D ; 139A,...,139D) ;
chaque extrémité (69A,...,69D) du circuit électrique (61; 161) étant reliée électriquement à l'un des points de contact (39A,...,39D ; 139A,...,139D).

4. Système (10) selon l'une quelconque des revendications précédentes, dans lequel le plan de fixation (40) forme la surface interne d'une face du boitier (14).

5. Système (110) selon l'une quelconque des revendications 1 à 3, dans lequel le plan de fixation (140) est reporté de chaque face du boitier (14) et isolé thermiquement de celle-ci.

6. Système (110) selon la revendication 5, dans lequel le plan de fixation (140) est ajouré.

7. Système (10 ; 110) selon l'une quelconque des revendications précédentes, dans lequel le régulateur thermique (16 ; 161) comporte en outre un module Peltier (70) couplé thermiquement à la partie sensible (47).

8. Système (10 ; 110) selon l'une quelconque des revendications précédentes, dans lequel chaque poutre (51A, 51B) et/ou la partie sensible (47) sont/est faite/faites d'un matériau à base de silicium.

9. Système (10 ; 110) selon l'une quelconque des revendications précédentes, comportant en outre une couche isolante (46) disposée entre la partie sensible (47) et les poutres (51A, 51B).

10. Système (10; 110) selon la revendication 9, comportant une couche intermédiaire (43) dans laquelle est gravée la partie sensible (47) et une couche inférieure (44) formant les poutres (51A, 51B) ;
la couche intermédiaire (43) et la couche inférieure (44) étant isolées électriquement et couplées thermiquement, via la couche isolante (46).

11. Système (10 ; 110) selon la revendication 10, dans lequel la couche inférieure (44) comporte en outre un substrat central (50) en contact avec la couche isolante (46) et couplant électriquement les poutres (51A, 51B).

12. Système (10 ; 110) selon l'une quelconque des revendications précédentes, dans lequel chaque poutre (51A, 51B) est un bras de découplage déformable en flexion.

13. Système (10 ; 110) selon l'une quelconque des revendications précédentes, formant un capteur, de préférence un capteur inertiel.

14. Système (10 ; 110) selon l'une quelconque des revendications précédentes, dans lequel chaque poutre (51A, 51B) est apte à émettre de la chaleur lorsqu'un courant électrique est engendré dans le circuit électrique (61 ; 161).

## Patentansprüche

1. Elektronisches System (10; 110), umfassend ein elektromechanisches Mikrosystem (12; 112) und ein hermetisches Gehäuse (14; 114) unter Vakuum, das dieses elektromechanische Mikrosystem (12; 112) einkapselt;
das Gehäuse (14; 114) umfassend eine Befestigungsebene (40; 140);
das elektromechanische Mikrosystem (12; 112) umfassend:
- einen empfindlichen Teil (47); und
- mindestens zwei Träger (51A, 51B), die den empfindlichen Teil (47) mit der Befestigungsebene (40; 140) verbinden;
wobei das System (10; 110) **dadurch gekennzeichnet ist**:
- **dass** jeder Träger (51A, 51B) aus einem zumindest teilweise leitfähigen Material gefertigt ist; und
- **dass** die Träger (51A, 51B) thermisch mit dem empfindlichen Teil (47) gekoppelt sind und elektrisch miteinander gekoppelt sind; und
- **dass** es ferner einen Temperaturregler (16; 116) des elektromechanischen Mikrosystems (12; 112) umfasst, umfassend einen Stromkreis (61; 161), umfassend mindestens zwei Enden (69A,..., 69D), die mit den Trägern (51A, 51B) verbunden sind, und eine Stromkreissteuerung (62), die einen elektrischen Strom in dem Stromkreis (61; 161) erzeugen kann, um die Temperatur des empfindlichen Teils (47) zu verändern.

2. System (10; 110) nach Anspruch 1, wobei der Temperaturregler (16; 116) ferner einen Elementarsensor (63) umfasst, der geeignet ist, um mindestens einen Parameter des empfindlichen Teils (47) zu messen, der sich abhängig von dessen Temperatur ändert;
wobei die Schaltungssteuerung (62) dazu geeignet ist, um einen elektrischen Strom in der elektrischen Schaltung (61; 161) abhängig von den Messungen zu erzeugen, die von dem Elementarsensor (63) bereitgestellt werden.

3. System (10; 110) nach Anspruch 1 oder 2, wobei jeder Träger (51A, 51B) über ein Befestigungselement (52A, 52B) mit der Befestigungsebene (40; 140) verbunden ist, das an einem Kontaktpunkt (39A,...,39D; 139A,...,139D) in diese Ebene (40; 140) integriert ist;
wobei jedes Ende (69A,...,69D) der elektrischen Schaltung (61; 161) elektrisch mit einem der Kontaktpunkte (39A,...,39D; 139A,...,139D) verbunden ist.

4. System (10) nach einem der vorherigen Ansprüche, wobei die Befestigungsebene (40) die Innenfläche einer Seite des Gehäuses (14) bildet.

5. System (110) nach einem der Ansprüche 1 bis 3, wobei die Befestigungsebene (140) von jeder Seite des Gehäuses (14) übertragen und thermisch davon isoliert ist.

6. System (110) nach Anspruch 5, wobei die Befestigungsebene (140) durchbrochen ist.

7. System (10; 110) nach einem der vorherigen Ansprüche, wobei der Temperaturregler (16; 161) ferner ein Peltier-Modul (70) umfasst, das thermisch mit dem empfindlichen Teil (47) gekoppelt ist.

8. System (10; 110) nach einem der vorherigen Ansprüche, wobei jeder Träger (51A, 51B) und/oder der empfindliche Teil (47) aus einem Material auf Siliziumbasis hergestellt sind/ist.

9. System (10; 110) nach einem der vorherigen Ansprüche, ferner umfassend eine Isolierschicht (46), die zwischen dem empfindlichen Teil (47) und den Trägern (51A, 51B) angeordnet ist.

10. System (10; 110) nach Anspruch 9, umfassend eine Zwischenschicht (43), in die der empfindliche Teil (47) eingeätzt ist, und eine untere Schicht (44), die die Träger (51A, 51B) bildet;
wobei die Zwischenschicht (43) und die untere Schicht (44) über die Isolierschicht (46) elektrisch isoliert und thermisch gekoppelt sind.

11. System (10; 110) nach Anspruch 10, wobei die untere Schicht (44) ferner ein mittleres Substrat (50) umfasst, das mit der Isolierschicht (46) in Kontakt ist und die Träger (51A, 51B) elektrisch koppelt.

12. System (10; 110) nach einem der vorherigen Ansprüche, wobei jeder Träger (51A, 51B) ein biegeverformbarer Entkopplungsarm ist.

13. System (10; 110) nach einem der vorherigen Ansprüche, das einen Sensor, vorzugsweise einen Trägheitssensor, bildet.

14. System (10; 110) nach einem der vorherigen Ansprüche, wobei jeder Träger(51A, 51B) geeignet ist, um Wärme abzugeben, wenn ein elektrischer Strom in der elektrischen Schaltung (61; 161) erzeugt wird.

## Claims

1. An electronic system (10; 110) comprising an electromechanical microsystem (12; 112) and a hermetic box (14; 114) under vacuum encapsulating said electromechanical microsystem (12; 112);
the box (14; 114) including a fastening plane (40; 140);
the electromechanical microsystem (12; 112) including:
- a sensitive part (47); and
- at least two beams (51A, 51B) connecting the sensitive part (47) to the fastening plane (40; 140);
the system (10; 110) being **characterized**:
- **in that** each beam (51A, 51B) being made from an at least partially conductive material;
- **in that** the beams (51A, 51B) are thermally coupled to the sensitive part (47) and are electrically coupled to one another; and
- **in that** it further includes a thermal regulator (16; 116) of the electromechanical microsystem (12; 112) including an electrical circuit (61; 161) including at least two ends (69A,...,69D) connected to the beams (51A, 51B), and a circuit controller (62) able to generate an electrical current in the electrical circuit (61; 161) to modify the temperature of the sensitive part (47).

2. The system (10; 110) according to claim 1, wherein the thermal regulator (16; 116) further includes an elementary sensor (63) able to measure at least one parameter of the sensitive part (47) varying as a function of the temperature thereof;
the circuit controller (62) being able to generate an electrical current in the electrical circuit (61; 161) as a function of the measurements supplied by the elementary sensor (63).

3. The system (10; 110) according to claim 1 or 2, wherein each beam (51A, 51B) is connected to the fastening plane (40; 140) via a fastening element (52A, 52B) integrated into said plane (40; 140) at a point of contact (39A,...,39D ; 139A,...,139D);
each end (69A,... ,69D) of the electrical circuit (61; 161) being electrically connected to one of the points of contact (39A,...,39D ; 139A,...,139D).

4. The system (10) according to any one of the preceding claims, wherein the fastening plane (40) forms the inner surface of a face of the box (14).

5. The system (110) according to any one of claims 1 to 3, wherein the fastening plane (140) is attached to each face of the box (14) and thermally insulated from the latter.

6. The system (110) according to claim 5, wherein the fastening plane (140) is open-worked.

7. The system (10; 110) according to any one of the preceding claims, wherein the thermal regulator (16; 161) further includes a Peltier module (70) thermally coupled to the sensitive part (47).

8. The system (10; 110) according to any one of the preceding claims, wherein each beam (51A, 51B) and/or the sensitive part (47) are/is made from a silicon-based material.

9. The system (10; 110) according to any one of the preceding claims, further including an insulating layer (46) arranged between the sensitive part (47) and the beams (51A, 51B).

10. The system (10; 110) according to claim 9, including an intermediate layer (43) in which the sensitive part (47) is etched and a lower layer (44) forming the beams (51A, 51B);
the intermediate layer (43) and the lower layer (44) being electrically insulated and thermally coupled, via the insulating layer (46).

11. The system (10; 110) according to claim 10, wherein the lower layer (44) further includes a central substrate (50) in contact with the insulating layer (46) and electrically coupling the beams (51A, 51B).

12. The system (10; 110) according to any one of the preceding claims, wherein each beam (51A, 51B) is a decoupling arm that is deformable in flexion.

13. The system (10; 110) according to any one of the preceding claims, forming a sensor, preferably an inertial sensor.

14. The system (10; 110) according to any one of the preceding claims, wherein each beam (51A, 51B) is able to emit heat when an electric current is generated in the electrical circuit (61; 161).
